(19) Europäisches Patentamt
European Patent Office
Office européen des brevets

(11) EP 4 607 335 A1

# (12) EUROPEAN PATENT APPLICATION

(43) Date of publication:
**27.08.2025 Bulletin 2025/35**

(21) Application number: **24176547.8**

(22) Date of filing: **17.05.2024**

(51) International Patent Classification (IPC):
***G06F 7/501*** *(2006.01)*

(52) Cooperative Patent Classification (CPC):
**G06F 7/501;** G06F 2207/4816

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **20.02.2024 IN 202441011932**
**26.03.2024 KR 20240041332**

(71) Applicant: **Samsung Electronics Co., Ltd.**
**Suwon-si, Gyeonggi-do 16677 (KR)**

(72) Inventors:
- **GOYAL, Mitesh**
  **560048 Bengaluru (IN)**
- **DHANAWADE, Mayuresh**
  **560048 Bengaluru (IN)**
- **GHOSH, Abhishek**
  **560048 Bengaluru (IN)**
- **GARG, Utkarsh**
  **560048 Bengaluru (IN)**
- **VINOD**
  **560048 Bengaluru (IN)**

(74) Representative: **Marks & Clerk LLP**
**15 Fetter Lane**
**London EC4A 1BW (GB)**

Remarks:
Amended claims in accordance with Rule 137(2) EPC.

## (54) FULL ADDER CIRCUIT AND METHODS FOR HIGH SPEED COMPUTING APPLICATIONS

(57) A Full Adder (FA) circuit includes a Carry Output Generation (COG) circuit including a first set of inverter gates to generate inverted input signals, and AND gates connected to the first set of inverter gates to generate a first output signal from the inverted input signals. An OR gate is connected to the AND gates, and a second inverter gate is connected to the OR gate. The OR gate generates a second output signal from the first output signal, and the second inverter gate generates a Carry Output (CO) signal from the second output signal. A Sum Generation (SG) circuit is connected to the COG circuit. The SG circuit includes a first cascaded block of transmission gates to generate an output from the CO signal, and a second cascaded block of transmission gates connected to the output of the first cascaded block of transmission gates to generate an output SUM signal.

FIG. 6

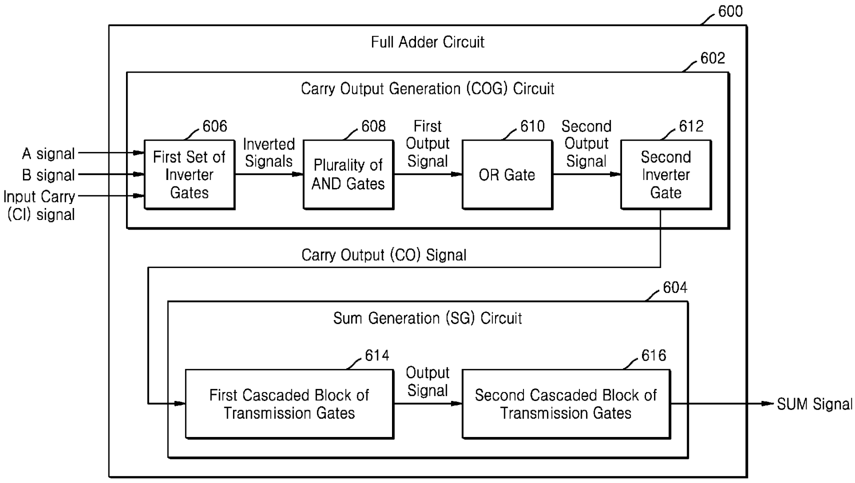


EP 4 607 335 A1

## Description

TECHNICAL FIELD

Example embodiments disclosed herein relate to adder circuits, and more particularly to a Full Adder (FA) circuit.

BACKGROUND

Generally, Full Adders (FA) and carry generators are the most critical combinational logic cells for Artificial Intelligence (AI)/ Machine Language (ML) and high performance computing applications. A Full Adder in an adder circuit adds three bits (two operands) and a carry in, to generate a sum bit and a carry out bit. Full Adder (FA) logic can be implemented using multiple transistors, inverters, and logical gates such as pass gates, AND gates, OR gates, XOR gates, and so on.

FIG. 1 depicts a conventional FA circuit used in a standard cell library which uses 28 transistors. FIG. 2 depicts a conventional FA circuit used in a basic standard cell library which uses 30 transistors. FIG. 3 depicts a conventional FA circuit used in the basic standard cell library which uses 32 transistors. FIG. 4 depicts a conventional FA circuit used in the basic standard cell library which uses 32 transistors.

A Carry Out (CO) is a majority function (median operator) of A, B, and Carryin (CI). A Sum (S) is XOR function of A, B, and Carryin (CI). FIG. 5A depicts a conventional logic gate diagram of a Carry Out generator circuit. FIG. 5B depicts a Carry Out generator core circuit of the logic gate diagram depicted in FIG. 5A.

Conventional FA circuits are designed for low power delay products and lowest possible applications. For high speed applications, a low latency Carryin to carryout paths are needed for highly timing constraint designs. In existing circuits, an adder Carryin pin is connected to six transistors while the output stage is connected to four transistors. Further, each input of the FA circuit is connected in a cascaded manner. Due to heavy loading of the transistors, the speed of operation and internal propagation delay of the design can degrade. In addition, conventional and known designs are not optimized for two critical input states, such as A=0, B=1 and A=1, B=0 states. Other known FA circuits are pass gate based circuits which have low reliability to noise and signal deformities due to coupling. In other known FA circuits, multiple stages are used in cascaded manner which can degrade the circuit performance. Further, the SUM generation circuit has triple stacks and high capacitance nets, which can degrade the overall performance.

Thus, existing FA circuits have high input capacitance on relevant nets. Further, at input of slow rising/falling signal, stacked (cascaded) transistors degrade internal slews and delays.

OBJECTS

An object of example embodiments herein is to disclose an ultra-high speed Full Adder (FA) circuit and methods for high speed circuit applications such as arc wise and pin specific latency optimization.

Another object of example embodiments herein is to disclose an FA circuit which is implemented in lesser number of stages and transistors, and provides competitive performance at high input.

Another object of example embodiments herein is to disclose an FA circuit which is structured as Complementary Metal-Oxide-Semiconductor (CMOS) base static logic circuit to make optimal use of the transistors and limit the net and transistor input capacitance.

Another object of example embodiments herein is to disclose an FA circuit designed with a pass gate based SUM generation circuit for obtaining high speed performance compared to conventional FA circuits.

Other objects and advantages of various example embodiments will become apparent to one of ordinary skill in the art upon consideration of the present disclosure.

SUMMARY

Accordingly, the example embodiments herein provide a Full Adder (FA) circuit. The FA circuit comprises a Carry Output Generation (COG) circuit and a Sum Generation (SG) circuit. The COG circuit further comprises a first set of inverter gates, a plurality of AND gates, an OR gate, and a second inverter gate. The first set of inverter gates is configured to receive a plurality of inputs and generate a plurality of inverted signals of the inputs. The first set of inverter gates may include at least a first inverter gate). The plurality of AND gates are connected to the first set of inverter gates configured to generate a first output signal from the inverted signals. The OR gate is connected to the plurality of AND gates. The OR gate is configured to generate a second output signal from the first output signal. The second inverter gate is connected to the OR gate, and is configured to generate a Carry Output (CO) signal from the second output signal. The SG circuit is connected to the COG circuit. The SG circuit includes a first cascaded block of transmission gates and a second cascaded block of transmission gates. The first cascaded block of transmission gates is configured to generate an output from the CO signal. The second cascaded block of transmission gates is connected to the output of the first cascaded block of transmission gates, and is configured to generate an output SUM signal.

Accordingly, the example embodiments herein provide a method for performing an ultra-high speed operation using the FA circuit. The method comprises generating, by the COG circuit of the FA circuit, a plurality of inverted signals of a plurality of inputs using the first set of inverter gates. Subsequently, the method comprises generating, by the COG circuit of the FA circuit, a first output signal from the inverted signals using a plurality of AND gates. The method comprises generating, by the COG circuit of the FA circuit, a second output signal from the first output signal using an OR gate. The method comprises generating, by the COG circuit of the FA circuit, a Carry Output (CO) signal from the second output signal using a second inverter gate. Thereafter, the method comprises generating, by the SG circuit of the FA circuit, an output SUM signal from the CO signal using the first cascaded block of transmission gates and the second cascaded block of transmission gates.

These and other aspects of the example embodiments herein will be better appreciated and understood when considered in conjunction with the following description and the accompanying drawings. It should be understood, however, that the following descriptions, while indicating example embodiments and numerous specific details thereof, are given by way of illustration and not of limitation. Many changes and modifications may be made within the scope of the example embodiments herein without departing from the scope of the invention as defined by the claims. At least some of the above and other features of the invention are set out in the claims.

## BRIEF DESCRIPTION OF FIGURES

Embodiments herein are illustrated in the accompanying drawings, throughout which like reference letters indicate corresponding parts in the various figures. Embodiments herein are illustrated by way of examples in the accompanying drawings, and in which:

FIG. 1 depicts a FA circuit used in a standard cell library which uses 28 transistors, according to existing arts;
FIG. 2 depicts a FA circuit used in a basic standard cell library which uses 30 transistors, according to existing arts;
FIG. 3 depicts a FA circuit used in the basic standard cell library which uses 30 transistors, according to existing arts;
FIG. 4 depicts a FA circuit used in the basic standard cell library which uses 32 transistors, according to existing arts;
FIG. 5A depicts a logic gate diagram of a Carry Out generator circuit, according to existing arts;
FIG. 5B depicts a Carry Out generator core circuit of the logic gate diagram depicted in FIG. 5A, according to existing arts;
FIG. 6 depicts a block diagram illustrating a Full Adder (FA) circuit, according to example embodiments as disclosed herein;
FIG. 7 depicts a core circuit of the FA circuit, according to example embodiments as disclosed herein;
FIG. 8 depicts an core circuit of the FA circuit, according to example embodiments as disclosed herein;
FIG. 9 depicts an core circuit of the FA circuit, according to example embodiments as disclosed herein;
FIG. 10 depicts an core circuit of the FA circuit, according to example embodiments as disclosed herein;
FIG. 11 depicts a logic gate diagram of the COG circuit, according to example embodiments as disclosed herein; and
FIG. 12 is a flow diagram illustrating a method for performing an ultra-high speed operation using a FA circuit, according to example embodiments as disclosed herein.

## DETAILED DESCRIPTION

Various example embodiments disclosed herein describe a Full Adder (FA) circuit configured to provide ultra-high speed performance. Various example embodiments may be implemented in high speed circuit applications, such as arc wise and pin specific latency optimization. Example embodiments of the FA circuit may be implemented in fewer stages, and using fewer transistors, while still providing competitive performance at high input rates. The FA circuit of at least one example embodiment is structured as Complementary Metal-Oxide-Semiconductor (CMOS) base static logic circuit to make optimal use of the transistors and limit the net and transistor input capacitance. At least one embodiment of the FA circuit includes a pass gate based SUM generation circuit, which may provide improved high speed performance compared to conventional FA circuits.

The example embodiments herein and the various features and advantageous details thereof are explained more fully with reference to the non-limiting example embodiments that are illustrated in the accompanying drawings and detailed in the following description. Descriptions of well-known components and processing techniques are omitted so as to not unnecessarily obscure the example embodiments herein. The examples used herein are intended merely to facilitate an understanding of ways in which the example embodiments herein may be practiced and to further enable those of skill in the art to practice the example embodiments herein. Accordingly, the examples should not be construed as limiting the scope of the example embodiments herein.

For the purposes of interpreting this specification, the definitions (as defined herein) will apply and whenever appropriate the terms used in singular will also include the plural and vice versa. It is to be understood that the terminology used herein is for the purposes of describing particular example embodiments only and is not intended to be limiting. The terms "comprising", "having" and "including" are to be construed as open-ended terms unless otherwise noted.

The words/phrases "exemplary", "example", "illustration", "in an instance", "and the like", "and so on", "etc.", "etcetera", "e.g.," , "i.e.," are merely used herein to mean "serving as an example, instance, or illustration." Any example embodiment or implementation of the present subject matter described herein using the words/phrases "exemplary", "example", "illustration", "in an instance", "and the like", "and so on", "etc.", "etcetera", "e.g.," and/or "i.e.," is not necessarily to be construed as preferred or advantageous over other example embodiments.

Example embodiments herein may be described and illustrated in terms of blocks which carry out a described function or functions. These blocks, which may be referred to herein as managers, units, modules, hardware components or the like, are physically implemented by analog and/or digital circuits such as logic gates, integrated circuits, microprocessors, microcontrollers, memory circuits, passive electronic components, active electronic components, optical components, hardwired circuits and the like, and may optionally be driven by a firmware. The circuits may, for example, be embodied in one or more semiconductor chips, or on substrate supports such as printed circuit boards and the like. The circuits constituting a block may be implemented by dedicated hardware, or by a processor (e.g., one or more programmed microprocessors and associated circuitry), or by a combination of dedicated hardware to perform some functions of the block and a processor to perform other functions of the block. Each block of the example embodiments may be physically separated into two or more interacting and discrete blocks without departing from the scope of the disclosure. Likewise, the blocks of the example embodiments may be physically combined into more complex blocks without departing from the scope of the disclosure.

It should be noted that elements in the drawings are illustrated for the purposes of this description and ease of understanding and may not have necessarily been drawn to scale. For example, the flowcharts/sequence diagrams illustrate the method in terms of the steps required for understanding of aspects of the example embodiments as disclosed herein. Furthermore, in terms of the construction of the device, one or more components of the device may have been represented in the drawings by conventional symbols, and the drawings may show only those specific details that are pertinent to understanding the present example embodiments so as not to obscure the drawings with details that will be readily apparent to those of ordinary skill in the art having the benefit of the description herein. Furthermore, in terms of the system, one or more components/modules which comprise the system may have been represented in the drawings by conventional symbols, and the drawings may show only those specific details that are pertinent to understanding the present example embodiments so as not to obscure the drawings with details that will be readily apparent to those of ordinary skill in the art having the benefit of the description herein.

The accompanying drawings are used to help easily understand various technical features and it should be understood that the example embodiments presented herein are not limited by the accompanying drawings. As such, the present disclosure should be construed to extend to any modifications, equivalents, and substitutes in addition to those which are particularly set out in the accompanying drawings and the corresponding description. Usage of words such as first, second, third etc., to describe components/elements/steps is for the purposes of this description and should not be construed as sequential ordering/placement/occurrence unless specified otherwise.

Example embodiments herein provide an ultra-high speed Full Adder (FA) circuit with limited transistor count for high speed computing applications. Referring now to the drawings, and more particularly to FIGS. 6 through 12, where similar reference characters denote corresponding features consistently throughout the figures, there are shown example embodiments.

FIG. 6 depicts a block diagram illustrating a Full Adder (FA) circuit 600. The FA circuit 600 comprises a Carry Output Generation (COG) circuit 602 and a Sum Generation (SG) circuit 604. The COG circuit 602 is configured with a first set of inverter gates 606, a plurality of AND gates 608, an OR gate 610, and a second inverter gate 612.

In an example embodiment herein, the first set of inverter gates 606 can be configured to receive a plurality of inputs. The inputs comprise A signal, B signal, and an input carry (CI) signal. The first set of inverter gates 606 can generate a plurality of inverted signals from the inputs. The plurality of inverted signals comprises AN signal, BN signal, and CN signal which are generated from the inputs A signal, B signal and CI signal. In an example embodiment herein, the AN signal can be further applied to an inverter to obtain a AIBUF signal (see figures 7 to 10). Addionally or alternatively, the BN signal can be further applied to an inverter to obtain a BIBUF signal (see figures 7 to 9). The CN signal may be further applied to an inverter to obtain a CNBUF signal. The, or each, inverter acts as a buffer and comprises of a static Complementary Metal-Oxide-Semiconductor (CMOS) inverter. The plurality of AND gates 608 are connected to the first set of inverter gates 606. The AND gates 608 can generate a first output signal from the generated inverted signals. The OR gate 610 is connected to the output of the plurality of AND gates 608. The OR gate 610 can generate a second output signal from the first output signal. The second inverter gate 612 is connected to the OR gate 610. The second inverter gate 612 can generate a Carry Output (CO) signal from the second output signal.

In an example embodiment herein, the SG circuit 604 is connected to the COG circuit 602. The SG circuit 604 further comprises a first cascaded block of transmission gates 614 and a second cascaded block of transmission gates 616. The first cascaded block of transmission gates 614 is configured to receive the CO signal from the COG circuit 602. The first cascaded block of transmission gates 614 can generate an output signal from the CO signal. The second cascaded block of transmission gates 616 is connected to the first cascaded block of transmission gates 614 to receive the output signal. The second cascaded block of transmission gates 616 can generate an output SUM signal. In an example embodiment herein, the second cascaded block of transmission gates 616 of the SG circuit 604 can be connected with at least one third inverter gate (see figure 7 for example) to generate the output SUM signal. In an example embodiment herein, at least one pass gate can be connected to the second cascaded block of transmission gates 616 and the third inverter gate of the SG circuit 604 to generate the output SUM signal.

In an example embodiment herein, the first set of inverter gates 606, the second inverter gate 612, and the third inverter gate comprise a fully static CMOS inverters.

FIG. 7 depicts a core circuit 700 of the Full Adder (FA) circuit 600. The core circuit 700 comprises a Carry Out (CO) section 702 and a Sum (S) section 704. The CO section 702 comprises the COG circuit 602 for generating the CO signal. The COG circuit 602 comprises the first set of inverter gates 606 where the first set of inverter gates 606 comprises three pairs of transistors. The pairs of transistors are connected in series to invert an input signal into an inverted signal. The transistors of the first set of inverter gates 606 receive A signal, B signal and CI signal as inputs and generate the inverted signals AN signal, BN signal, and CN signal. Further, a CMOS inverter is connected in parallel to a pair of transistors that generated the AN signal. The CMOS inverter comprises a series connected pair of transistors to transform the AN signal into the AIBUF signal.

An AOI (AND gates 608, OR gate 610, and second Inverter gate 612) circuit 706 is connected to the first set of inverter gates 606 comprising three pairs of transistors. The AOI circuit 706 is arranged in the COG circuit 602 in such a way that the AOI circuit 706 uses two shared transistors of the CN signal and four transistors for each of the AN signal and the BN signal. The output of the AOI circuit 706 is the CO signal.

The AN signal and the AIBUF signal are transmitted as inputs, and the B signal and the BN signal are transmitted as controlling inputs to the first cascaded block of transmission gates 614 of the SG circuit 604 to perform a bivariate XOR (XOR2) function. A classic XOR2 is performed using the AIBUF signal and AN signal as input to the transmission gates which are controlled by the B signal and the BN signal inputs. The first cascaded block of transmission gates 614 provides a fully noise resistance output of A XOR B signal as a Z net signal. The Z net signal is further inverted into a ZN signal using a third inverter gate 708. The third inverter gate 708 is connected to the output of the first cascaded block of transmission gates 614 and input of the second cascaded block of transmission gates 616 of the SG circuit 604.

The second cascaded block of transmission gates 616 receives the Z signal and the ZN signal as inputs, and the CI signal and the CN signal as controlling inputs. The second cascaded block of transmission gates 616 generates A XOR OR (Z net AND ZN) signal and provides a net output of A XOR B XOR CI as the output SUM signal from the A XOR OR (Z net AND ZN) signal.

In an example embodiment herein, the first cascaded block of transmission gates 614 and the second cascaded block of transmission gates 616 each comprise two pairs of transistors connected in series, where each pair of transistors comprises two transistors connected in parallel.

In another variant, the second cascaded block of transmission gates 616 generates a Z XNOR CI signal using the CN signal and the ZN signal as inputs, and the CI signal and the CN signal as controlling inputs. The second cascaded block of transmission gates 616 inverts the Z XNOR CI signal to provide the output of A XOR B XOR CI as the output SUM signal. This results in better drivability of the output nets. In still other embodiments, instead of using AIBUF, the BIBUF signals could be used analogously.

FIG. 8 depicts another core circuit 800 of the Full Adder (FA) circuit 600. The core circuit 800 comprises a Carry Out (CO) section 802 and a Sum (S) section 804. The CO section 802 comprises the COG circuit 602 for generating the CO signal. The COG circuit 602 comprises the first set of inverter gates 606 to receive A signal, B signal and CI signal as inputs and generate the inverted signals AN signal, BN signal, and CN signal. Further, two CMOS inverters are connected to the inverter gates 606 that generated the AN signal and the BN signal. Each CMOS inverter comprises a series connected pair of transistors to transform the AN signal into the AIBUF signal and the BN signal into the BIBUF signal.

The AOI (AND gates 608, OR gate 610, and second Inverter gate 612) circuit 706 is connected to the first set of inverter gates 606 comprising three pairs of transistors. The AOI circuit 706 uses two shared transistors of the CN signal and four transistors for each of the AN signal and the BN signal. The output of the AOI circuit 706 is the CO signal.

The AN signal and the AIBUF signal are transmitted as inputs, and the CI signal and the CN signal are transmitted as controlling inputs to the first cascaded block of transmission gates 614 of the SG circuit 604 to perform an XNOR function. The first cascaded block of transmission gates 614 provides an output of an A XNOR CI signal as a Y net signal. A pass gate 806 is connected is connected to the second cascaded block of transmission gates 616 and the third inverter gate 708 of the SG circuit 604. The pass gate 806 is a PMOS (p-channel Metal-Oxide Semiconductor) pass gate 806. The pass gate 806 comprises two transistors connected in parallel to the output of the first cascaded block of transmission gates 614. The pass gate 806 receives the BN signal, the BIBUF signal, and the Y net signal as inputs, and generates a Y XOR B (Y.BN+YN.BI (using the PMOS pass gate 806) + BN.Y (net90)) signal. In this example embodiment, the BN signal is given to a NMOS transistor 808 of the pass gate 806. The BIBUF signal is given to a PMOS transistor 810 of the pass gate 806. The BIBUF signal is given at source of the PMOS transistor 810 and gate is controlled by the Y net signal. Similarly, the BN signal is given on drain of the NMOS transistor 808 and gate is controlled by the Y net signal. Together the two NMOS transistor 808 and PMOS transistor 810 constitute the pass gate set 806. The third inverter gate 708 which is connected to the output of the pass gate 806 inverts the net90 signal generated by the pass gate 806. The second cascaded block of transmission gates 616 generates the output SUM signal from the generated Y XOR B signal and the inverted net90 signal.

In an example embodiment herein, the first cascaded block of transmission gates 614 comprise two pairs of transistors connected in series, where each pair of transistors comprises two transistors connected in parallel. The second cascaded block of transmission gates 616 comprises two transistors connected in parallel. In this example embodiment, the BN signal is given to the NMOS transistor 812 of the second cascaded block of transmission gates 616. The BIBUF signal is given to the PMOS 814 transistor of the second cascaded block of transmission gates 616. The BN signal is given at gate of the NMOS transistor 812 and source is controlled by the Y net signal. Similarly, the BIBUF signal is given at gate of the PMOS transistor 814 and source is controlled by the Y net signal.

In an example embodiment herein, the first cascaded block of transmission gates 614 is configured to perform a XOR function i.e., using a classical transmission based XOR controlled by the CI signal and the CN signal. The first cascaded block of transmission gates 614 further provides an output of an A XOR CI signal as a Y net signal, based on the XOR function. The pass gate 806 receives the BN signal and the BIBUF signal, and the Y net signal as inputs. The pass gate 806 generates a Y.B+YN.BN signal from the received inputs. The third inverter gate 708 which is connected to the output of the pass gate 806 inverts the generated Y.B+YN.BN signal. The second cascaded block of transmission gates 616 generates the output SUM signal from the generated Y.B+YN.BN signal and the inverted Y.B+YN.BN signal.

FIG. 9 depicts an alternate core circuit 900 of the Full Adder (FA) circuit 600. The core circuit 900 comprises a Carry Out (CO) section 902 and a Sum (S) section 904. The CO section 902 comprises the COG circuit 602 for generating the CO signal. The COG circuit 602 comprises the first set of inverter gates 606 to receive A signal, B signal and CI signal as inputs and generate the inverted signals AN signal, BN signal, and CN signal. Further, two CMOS inverters are connected to the inverter gates 606 that generated the AN signal and the BN signal. Each CMOS inverter comprises a series connected pair of transistors to transform the AN signal into the AIBUF signal and the BN signal into the BIBUF signal.

The AOI (AND gates 608, OR gate 610, and second Inverter gate 612) circuit 706 is connected to the first set of inverter gates 606. The AOI circuit 706 uses two shared transistors of the CN signal and four transistors for each of the AN signal and the BN signal. The output of the AOI circuit 706 is the CO signal.

The AN signal and the AIBUF signal are transmitted as inputs, and the CI signal and the CN signal are transmitted as controlling inputs to the first cascaded block of transmission gates 614 of the SG circuit 604 to perform an XNOR function. The first cascaded block of transmission gates 614 provides an output of an A XNOR CI signal as a Y net signal. A pass gate 806 is connected is connected to the second cascaded block of transmission gates 616 and the third inverter gate 708 of the SG circuit 604. The pass gate 806 comprises two transistors connected in parallel to the output of the first cascaded block of transmission gates 614. The pass gate 806 receives the BN signal, the BIBUF signal, and the Y net signal as inputs, and generates a Y XOR B (Y.BN+YN.BI (using the PMOS pass gate 806) + BN.Y (net90)) signal. In this example embodiment, the BIBUF signal is given to the NMOS transistor 808 of the pass gate 806. The BN signal is given to the PMOS transistor 810 of the pass gate. The BIBUF signal is given on drain of the NMOS transistor 808 and gate is controlled by the Y net signal. Similarly, the BN signal is given at source of the PMOS transistor 810 and gate is controlled by the Y net signal. The third inverter gate 708 which is connected to the output of the pass gate 806 inverts the net90 signal generated by the pass gate 806. The second cascaded block of transmission gates 616 generates the output SUM signal from the generated Y XOR B signal and the inverted net90 signal.

In an example embodiment herein, the first cascaded block of transmission gates 614 comprise two pairs of transistors connected in series, where each pair of transistors comprises two transistors connected in parallel. The second cascaded block of transmission gates 616 comprises two transistors connected in parallel. In this example embodiment, the BIBUF signal is given to the NMOS transistor 812 of the second cascaded block of transmission gates 616. The BN signal is given to the PMOS 814 transistor of the second cascaded block of transmission gates 616d. The BN signal is given at gate of the PMOS transistor 814 and source is controlled by the Y net signal. Similarly, the BIBUF signal is given at gate of the NMOS transistor 812 and source is controlled by the Y net signal.

In an example embodiment herein, the first cascaded block of transmission gates 614 is configured to perform a XOR function which is controlled by the CI signal and the CN signal. The first cascaded block of transmission gates 614 further provides an output of an A XOR CI signal as a Y net signal, based on the XOR function. The pass gate 806 receives the BN signal and the BIBUF signal, and the Y net signal as inputs and generates a Y.B+YN.BN signal. The third inverter gate 708 which is connected to the output of the pass gate 806 inverts the generated Y.B+YN.BN signal. The second cascaded block of transmission gates 616 generates the output SUM signal from the generated Y.B+YN.BN signal and the inverted Y.B+YN.BN signal.

FIG. 10 depicts another core circuit 1000 of the Full Adder (FA) circuit 600. The core circuit 1000 comprises a Carry Out (CO) section 1002 and a Sum (S) section 1004. The CO section 1002 comprises the COG circuit 602 for generating the CO signal. The COG circuit 602 comprises the first set of inverter gates 606 where the first set of inverter gates 606 comprises three pairs of transistors. The pair of transistors are connected in series to invert an input signal into an inverted signal. The transistors of the first set of inverter gates 606 receive A signal, B signal and CI signal as inputs and generate the inverted signals AN signal, BN signal, and CN signal. Further, a CMOS inverter is connected in parallel to a pair of transistors that generated the AN signal. The CMOS inverter comprises a series connected pair of transistors to transform the AN signal into the AIBUF signal. An AOI (AND gates 608, OR gate 610, and second Inverter gate 612) circuit 706 is connected to the first set of inverter gates 606. The output of the AOI circuit 706 is the CO signal.

The AN signal and the AIBUF signal are transmitted as inputs, and the B signal and the BN signal are transmitted as controlling inputs to the first cascaded block of transmission gates 614 of the SG circuit 604 to perform a bivariate XOR (XOR2) function. The first cascaded block of transmission gates 614 provides a fully noise resistance output of A XOR B signal as a Z net signal. The Z net signal is further inverted into a ZN signal using a third inverter gate 708.

The second cascaded block of transmission gates 616 receives the Z signal and the ZN signal as inputs, and the CI signal and the CN signal as controlling inputs. The second cascaded block of transmission gates 616 generates A XOR OR (Z net AND ZN) signal and provides a net output of A XOR B XOR CI as the output SUM signal from the A XOR OR (Z net AND ZN) signal. A supplementary inverter gate 1006 is connected to the output of the second cascaded block of transmission gates 616 to obtain the SUM signal (A XOR B XOR CI).

In another variant, the second cascaded block of transmission gates 616 generates a Z XNOR CI signal using the CN signal and the ZN signal as inputs, and the CI signal and the CN signal as controlling inputs. The second cascaded block of transmission gates 616 inverts the Z XNOR CI signal to provide the output of A XOR B XOR CI as the output SUM signal. Further, the supplementary inverter gate 1006 inverts to obtain the SUM signal (A XOR B XOR CI) as output.

FIG. 11 depicts a logic gate diagram of the COG circuit 602. The COG circuit 602 comprises a first set of inverter gates 606 and a AOI circuit 706. The first set of inverter gates 606 comprises three inverter gates 1102, 1104, and 1106. The inverter gates 1102, 1104, and 1106 are connected with inputs as A signal, B signal, and a CI signal. The inverter gates 1102, 1104, and 1106 generate the inverted signals AN signal, BN signal, and CN signal from the inputs A signal, B signal, and an CI signal. The AOI circuit 706 is coupled to the first set of inverter gates 606. The AOI circuit 706 comprises three AND gates 1108, 1110, and 1112, an OR gate 610, and a second inverter gate 612. The AND gates 1108, 1110, and 1112 are coupled to the inverted signals AN signal, BN signal, and CN signal which are obtained from the three inverter gates 1102, 1104, and 1106. The AND gates 1108, 1110, and 1112 generate outputs as a first output signal which is connected to the OR gate 610. The OR gate 610 generates a second output signal from the first output signal. The second inverter gate 612 is coupled to the OR gate 610. The second inverter gate 612 generates a CO signal from the second output signal. Thus, the proposed design of the COG circuit 602 of the Full Adder (FA) circuit 600 comprises inversion of the inputs which greatly reduces the input capacitance.

FIG. 12 illustrates a method 1200 for performing an ultra-high speed operation using a FA circuit 600. The method 1200 comprises generating, by the COG circuit 602 of the FA circuit 600, a plurality of inverted signals of a plurality of inputs using a first set of inverter gates 606, as depicted in step 1202. The method 1200 comprises generating, by the COG circuit 602 of the FA circuit 600, a first output signal from the inverted signals using a plurality of AND gates 608, as depicted in step 1204.

Thereafter, the method 1200 comprises generating, by the COG circuit 602 of the FA circuit 600, a second output signal from the first output signal using an OR gate 610, as depicted in step 1206. The method 1200 comprises generating, by the COG circuit 602 of the FA circuit 600, a CO signal from the second output signal using a second inverter gate 612, as depicted in step 1208. Further, the method 1200 comprises generating, by the SG circuit 604 of the FA circuit 600, an output SUM signal from the CO signal using the first cascaded block of transmission gates 614 and a second cascaded block of transmission gates 616, as depicted in step 1210.

The various actions in method 1200 may be performed in the order presented, in a different order or simultaneously. Further, in some example embodiments, some actions listed in FIG. 12 may be omitted.

In an example embodiment herein, based on Boolean analysis, the Carry Out is a majority function which is given as,

M = A.B + B.C + C.A, where C is a CI signal.

The proposed FA circuit 600 can be implemented with the majority function as given below for providing slower slews,

$$M = \overline{\overline{A}.\overline{B} + \overline{C}.\overline{A} + \overline{B}.\overline{C}}$$

Thus, the proposed FA circuit 600 can invert the signals first and then perform the algebraic calculation on stacked device. This improves the internal propagation delay in a cell, thereby providing high performance.

Further, the SUM output signal is given by:

$$S = A\ XOR\ B\ XOR\ C$$

$$S = AN.BN.C + AN.B.C + A.YN.CN + A.B.C$$

The SUM output signal can be implemented in a single stage using a pass gate logic. However, only A1B0 and A0B1: Carryin to CarryOut arcs are important, as shown in table 1. Therefore, the FA circuit 600 can be optimized in two variants. First variant is for A1B0 and second variant is for A0B1. The FA circuit 600 optimization with the variants is shown in the table 1.

| Inputs | | | Outputs | |
|---|---|---|---|---|
| A | B | $C_{in}$ | Sum | Carry |
| 0 | 0 | 0 | 0 | 0 |
| 0 | 0 | 1 | 1 | 0 |
| 0 | 1 | 0 | 1 | 0 |
| 0 | 1 | 1 | 0 | 1 |
| 1 | 0 | 0 | 1 | 0 |
| 1 | 0 | 1 | 0 | 1 |
| 1 | 1 | 0 | 0 | 1 |
| 1 | 1 | 1 | 1 | 1 |

**Table 1**

The proposed FA circuit 600 can be applicable in mobile phones, cameras, TV, high speed standard cell library applications, high performance computing, Artificial Intelligence and Machine Learning GPUs, full custom ripple carry adders, highly slew constraint and long signal nets, Arithmetic Logic unit and signal multiplexing in high speed modems, and so on. The FA circuit 600 has four transistors on input stage and four transistors on output stage (out of total two transmission stages) in the SG circuit 604 of a full adder configuration.

The proposed example embodiments of the FA circuit 600 are highly optimized for Carryin to CarryOut path. In this configuration, as the SG circuit 604 is a pass gate based circuit, the FA circuit 600 is overall faster on all the arcs. The FA circuit 600 has a better transistor count compared to known high speed adders. The FA circuit 600 is structured with CMOS base static logic circuit that makes optimal use of the transistors and limits the net and transistor input capacitance. The inputs of the COG circuit 602 of the FA circuit 600 are connected to two CMOS that considerably reduces the input capacitance. Further, the proposed FA circuit 600 is implemented in lesser number of stages which provides competitive performance at high input slews. The FA circuit 600 is a fully static design based on a method driven Boolean analysis. Thus, the circuit is fully optimized for applicable and practical high speed circuit applications like arc wise and pin specific latency optimization.

When an element is referred to as being "on," "connected to," "coupled to," or "adjacent to," another element, the element may be directly on, connected to, coupled to, or adjacent to, the other element, or one or more other intervening elements may be present. In contrast, when an element is referred to as being "directly on," "directly connected to," "directly coupled to," or "immediately adjacent to," another element there are no intervening elements present.

In various example embodiments herein, reference may have been made to various circuit elements, including but not limited to capacitors, resistor, inductors, switches, amplifiers, comparators, filters, and transistors. Various different types of digital, analog, active and/or passive components are available for use in implementing the example embodiments. Additionally various different transistor types can be used depending on the implementation, whether positive or negative logic is used, manufacturing processes employed, or the like. Furthermore, unless specifically stated otherwise herein, there are many available types of filters, comparators, switches, and the like that can be used to implement the example embodiments.

Some example embodiments disclosed herein can be implemented through at least one software program running on at least one hardware device. The components of the FA circuit 600 shown in FIG. 6 include blocks which can be at least one of a hardware device, or a combination of hardware device and software module.

The foregoing description of the specific example embodiments will so fully reveal the general nature of the example embodiments herein that others can, by applying current knowledge, readily modify and/or adapt for various applications such specific example embodiments without departing from the generic concept, and, therefore, such adaptations and modifications should and are intended to be comprehended within the meaning and range of equivalents of the disclosed example embodiments. It is to be understood that the phraseology or terminology employed herein is for the purpose of description and not of limitation. Therefore, while the example embodiments herein have been described in terms of example embodiments and examples, those skilled in the art will recognize that the example embodiments and examples disclosed herein can be practiced with modification within the scope of the example embodiments as described herein.

## Claims

1. A Full Adder (FA) circuit, comprising:

    a Carry Output Generation (COG) circuit including

        a first set of inverter gates configured to receive a plurality of inputs and generate a plurality of inverted signals of the plurality of inputs,
        a plurality of AND gates connected to the first set of inverter gates, wherein the plurality of AND gates is configured to generate a first output signal from the plurality of inverted signals,
        an OR gate connected to the plurality of AND gates, wherein the OR gate is configured to generate a second output signal from the first output signal, and
        a second inverter gate connected to the OR gate, wherein the second inverter gate is configured to generate a Carry Output (CO) signal from the second output signal;

    a Sum Generation (SG) circuit connected to the COG circuit, wherein the SG circuit includes

        a first cascaded block of transmission gates, wherein the first cascaded block of transmission gates is configured to generate an output from the CO signal, and
        a second cascaded block of transmission gates connected to the output of the first cascaded block of transmission gates, wherein the second cascaded block of transmission gates is configured to generate an output SUM signal.

2. The FA circuit as claimed in claim 1, wherein the plurality of inputs comprises an A signal, a B signal, and an input carry (CI) signal, wherein the plurality of inverted signals comprises an AN signal, a BN signal, and a CN signal.

3. The FA circuit as claimed in claim 2, wherein the FA circuit includes one or more of:

    a first inverter configured to generate an AIBUF signal based on the AN signal,
    a second inverter configured to generate a BIBUF signal based on the BN signal, and
    a third inverter configured to generate a CNBUF signal based on the CN signal, and wherein the or each of the first inverter, the second inverter, and/ or the third inverter comprise static CMOS inverters.

4. The FA circuit as claimed in claim 3, wherein the first cascaded block of transmission gates of the SG circuit is configured to perform a bivariate XOR (XOR2) function using the AN signal and the AIBUF signal as inputs, and the B signal and the BN signal as controlling inputs, to provide an output of A XOR B signal as a Z net signal, and wherein the at least one third inverter gate is configured to invert the Z net signal to generate a ZN signal.

5. The FA circuit as claimed in claim 4, wherein the second cascaded block of transmission gates is configured to generate an A XOR OR (Z net AND ZN) signal using the CN signal and the ZN signal as inputs, and the CI signal and the CN signal as controlling inputs to provide an output of A XOR B XOR CI as the output SUM signal, wherein the second cascaded block of transmission gates is configured to generate a Z XNOR CI signal using the CN signal and the ZN signal as inputs, and the CI signal and the CN signal as controlling inputs, and inverts the Z XNOR CI signal to provide the output of A XOR B XOR CI as the output SUM signal.

6. The FA circuit as claimed in claim 3, 4 or 5, wherein the first cascaded block of transmission gates of the SG circuit is configured to perform an XNOR function using the AN signal and the AIBUF signal as inputs and the CI signal and the CN signal as controlling inputs, and provide an output of an A XNOR CI signal as a Y net signal.

7. The FA circuit as claimed in claim 6, wherein the at least one pass gate is configured to generate a Y XOR B (Y.BN+YN.BI+BN.Y(net90)) signal using the BN signal, the BIBUF signal, and the Y net signal as inputs, and, wherein the at least one third inverter gate (708) is configured to invert the net90 signal to generate an inverted net90 signal, wherein the second cascaded block of transmission gates is configured to generated the output SUM signal from the generated Y XOR B signal and the inverted net90 signal.

**8.** The FA circuit as claimed in any one of claims 3 to 7, wherein the first cascaded block of transmission gates of the SG circuit is configured to perform an XOR function using the AN signal and the AIBUF signal as inputs, and the CI signal and the CN signal as controlling inputs, and provide an output of an A XOR CI signal as a Y net signal.

**9.** The FA circuit as claimed claim 8, wherein the at least one pass gate is configured to generate a Y.B+YN.BN signal using the BN signal and the BIBUF signal, and the Y net signal as inputs, wherein the at least one third inverter gate is configured to invert the generated Y.B+YN.BN signal received from the at least one pass gate, wherein the second cascaded block of transmission gates is configured to generate the output SUM signal from the generated Y.B+YN.BN signal and the inverted Y.B+YN.BN signal.

**10.** The FA circuit as claimed in any one of claims 1 to 9, wherein the second cascaded block of transmission gates of the SG circuit is connected to at least one third inverter gate, and wherein at least one pass gate is connected to the second cascaded block of transmission gates and the at least one third inverter gate of the SG circuit.

**11.** The FA circuit as claimed in claim 10, wherein the first set of inverter gates, the second inverter gate, and the at least one third inverter gate comprise fully static Complementary Metal oxide semiconductor (CMOS) inverters.

**12.** A method for using a Full Adder (FA) circuit, comprising:

generating, by a Carry Output Generation (COG) circuit of the FA circuit, a plurality of inverted signals of a plurality of inputs using a first set of inverter gates;
generating, by the COG circuit of the FA circuit (600), a first output signal from the plurality of inverted signals using a plurality of AND gates (608);
generating, by the COG circuit of the FA circuit, a second output signal from the first output signal using an OR gate;
generating, by the COG circuit of the FA circuit, a Carry Output (CO) signal from the second output signal using a second inverter gate; and
generating, by a Sum Generation (SG) circuit of the FA circuit, an output SUM signal from the CO signal using a first cascaded block of transmission gates and a second cascaded block of transmission gates.

**13.** The method as claimed in claim 12, wherein the plurality of inputs comprises an A signal, a B signal, and an input carry (CI) signal, wherein the plurality of inverted signals comprises an AN signal, a BN signal, and a CN signal.

**14.** The method as claimed in claim 13, comprising at least one of:

the AN signal is applied to a first inverter to obtain a AIBUF signal,
the BN signal is applied to a second inverter to obtain a BIBUF signal,
the CN signal is applied to a third inverter to obtain a CNBUF signal, and
wherein the, or each of, first inverter, the second inverter, and the third inverter comprise static CMOS inverters.

**15.** The method as claimed in claim 12, 13 or 14, wherein generating the output SUM signal includes using at least one pass gate connected to the second cascaded block of transmission gates of the SG circuit and to at least one third inverter gate of the SG circuit.

**Amended claims in accordance with Rule 137(2) EPC.**

**1.** A Full Adder, FA, circuit, comprising:

a Carry Output Generation, COG, circuit (602) including

a first set of inverter gates (606) configured to receive a plurality of inputs and generate a plurality of inverted signals of the plurality of inputs,
a plurality of AND gates (608) connected to the first set of inverter gates (606), wherein the plurality of AND gates is configured to generate a first output signal from the plurality of inverted signals,
an OR gate (610) connected to the plurality of AND gates (608), wherein the OR gate is configured to generate a second output signal from the first output signal, and

a second inverter gate (612) connected to the OR gate (610), wherein the second inverter gate is configured to generate a Carry Output, CO, signal from the second output signal;

a Sum Generation (SG) circuit (604) connected to the COG circuit (602), wherein the SG circuit includes:

a first cascaded block of transmission gates (614), wherein the first cascaded block of transmission gates is configured to generate an output from one or more of the plurality of inputs and one or more of the plurality of inverted signals of the plurality of inputs, and
a second cascaded block of transmission gates (616) connected to the output of the first cascaded block of transmission gates (614), wherein the second cascaded block of transmission gates is configured to generate an output SUM signal.

**2.** The FA circuit as claimed in claim 1, wherein the plurality of inputs comprises an A signal, a B signal, and an input carry, CI, signal, wherein the plurality of inverted signals comprises an AN signal, a BN signal, and a CN signal.

**3.** The FA circuit as claimed in claim 2, wherein the FA circuit (600) includes one or more of:

a first inverter configured to generate an AIBUF signal based on the AN signal,
a second inverter configured to generate a BIBUF signal based on the BN signal, and
a third inverter (708) configured to generate a CNBUF signal based on the CN signal, and wherein the or each of the first inverter, the second inverter, and/ or the third inverter comprise static CMOS inverters.

**4.** The FA circuit as claimed in claims 1, 2 or 3, wherein the second cascaded block of transmission gates (616) of the SG circuit (604) is connected to at least one third inverter gate (708), and wherein at least one pass gate (806) is connected to the second cascaded block of transmission gates (616) and the at least one third inverter gate of the SG circuit.

**5.** The FA circuit as claimed in claim 4, wherein the first set of inverter gates (606), the second inverter gate (612), and the at least one third inverter gate (708) comprise fully static Complementary Metal oxide semiconductor inverters.

**6.** The FA circuit as claimed in claim 3, wherein the first cascaded block of transmission gates (614) of the SG circuit (604) is configured to perform a bivariate XOR (XOR2) function using the AN signal and the AIBUF signal as inputs, and the B signal and the BN signal as controlling inputs, to provide an output of A XOR B signal as a Z net signal, and wherein the at least one third inverter gate is configured to invert the Z net signal to generate a ZN signal.

**7.** The FA circuit as claimed in claim 6, wherein the second cascaded block of transmission gates (616) is configured to generate a Z XOR CI signal using the Z signal and the ZN signal as inputs, and the CI signal and the CN signal as controlling inputs to provide an output of A XOR B XOR CI as the output SUM signal.

**8.** The FA circuit as claimed in claim 4 or 5, wherein the first cascaded block of transmission gates (614) of the SG circuit (604) is configured to perform an XNOR function using the AN signal and the AIBUF signal as inputs and the CI signal and the CN signal as controlling inputs, and provide an output of an A XNOR CI signal as a Y net signal.

**9.** The FA circuit as claimed in claim 8, wherein the at least one pass gate is (806) configured to generate a Y XOR B (Y.BN+YN.BI+BN.Y) signal using the BN signal, the BIBUF signal, and the Y net signal as inputs, and, wherein the at least one third inverter gate (708) is configured to invert the Y XOR B signal to generate an inverted Y XOR B signal, wherein the second cascaded block of transmission gates is configured to generated the output SUM signal from the generated Y XOR B signal and the inverted Y XOR B signal.

**10.** The FA circuit as claimed in claim 4 or 5, wherein the first cascaded block of transmission gates (614) of the SG circuit (604) is configured to perform an XOR function using the AN signal and the AIBUF signal as inputs, and the CI signal and the CN signal as controlling inputs, and provide an output of an A XOR CI signal as a Y net signal.

**11.** The FA circuit as claimed claim 10, wherein the at least one pass gate (806) is configured to generate a Y.B+YN.BN signal using the BN signal and the BIBUF signal, and the Y net signal as inputs, wherein the at least one third inverter gate (708) is configured to invert the generated Y.B+YN.BN signal received from the at least one pass gate, wherein the second cascaded block of transmission gates (616) is configured to generate the output SUM signal from the generated Y.B+YN.BN signal and the inverted Y.B+YN.BN signal.

**12.** A method for using a FA circuit, comprising:

generating, by a COG circuit (602) of the FA circuit (600), a plurality of inverted signals of a plurality of inputs using a first set of inverter gates (606);
generating, by the COG circuit (602) of the FA circuit (600), a first output signal from the plurality of inverted signals using a plurality of AND gates (608);
generating, by the COG circuit(602) of the FA circuit, a second output signal from the first output signal using an OR gate;
generating, by the COG circuit (602) of the FA circuit, a CO signal from the second output signal using a second inverter gate (612); and
generating, by a SG circuit (604) of the FA circuit, an output SUM signal from the one or more of the plurality of inputs and one or more of the plurality of inverted signals of the plurality of inputs using a first cascaded block of transmission gates (614) and a second cascaded block of transmission gates (616).

**13.** The method as claimed in claim 12, wherein the plurality of inputs comprises an A signal, a B signal, and an input carry (CI) signal, wherein the plurality of inverted signals comprises an AN signal, a BN signal, and a CN signal.

**14.** The method as claimed in claim 13, comprising at least one of:

the AN signal is applied to a first inverter to obtain a AIBUF signal,
the BN signal is applied to a second inverter to obtain a BIBUF signal,
the CN signal is applied to a third inverter (708) to obtain a CNBUF signal, and
wherein the, or each of, the first inverter, the second inverter, and the third inverter comprise static CMOS inverters.

**15.** The method as claimed in claim 12, 13 or 14, wherein generating the output SUM signal includes using at least one pass gate (806) connected to the second cascaded block of transmission gates (616) of the SG circuit (604) and to at least one third inverter gate (806) of the SG circuit (604).

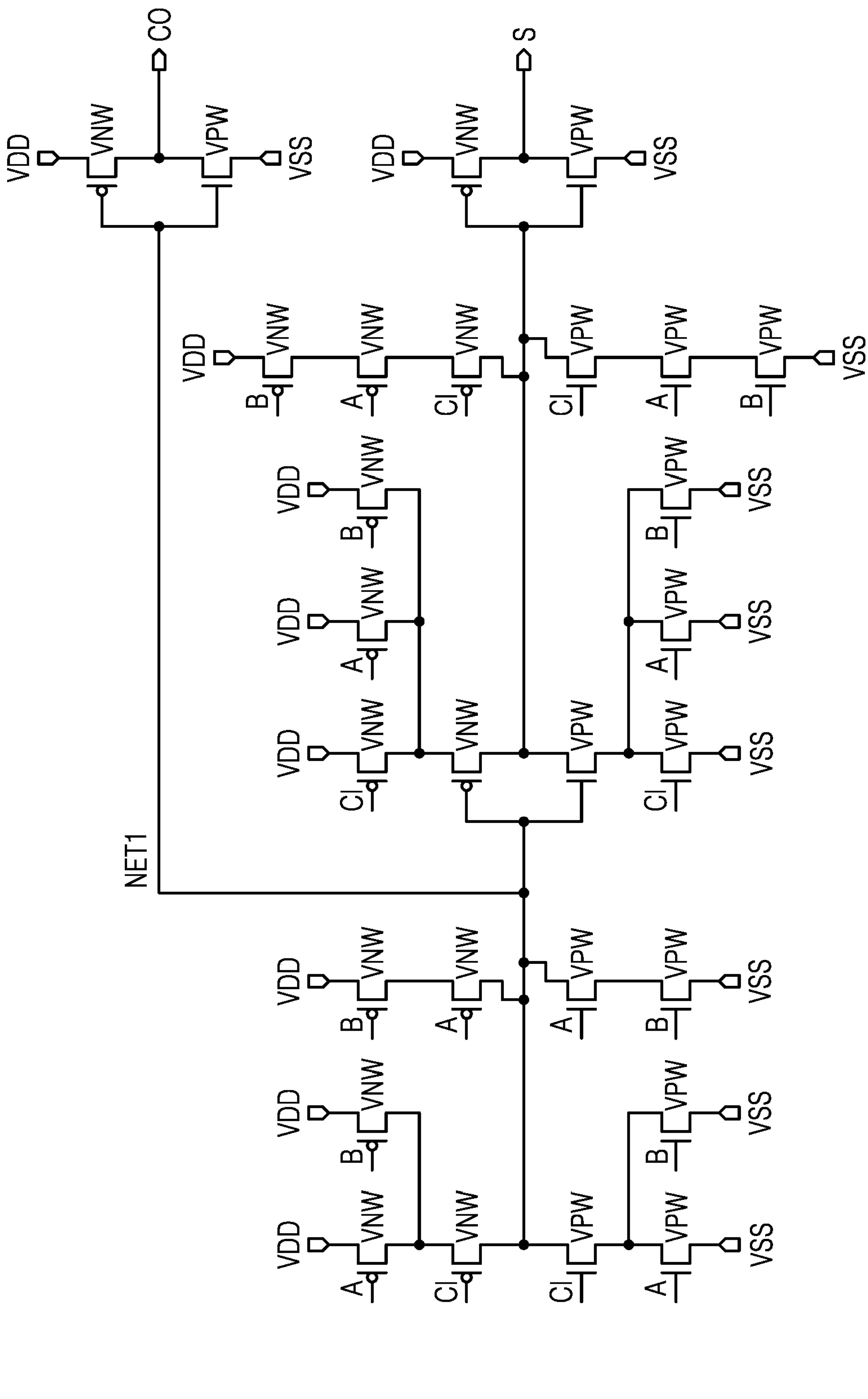


FIG. 1 (PRIOR ART)

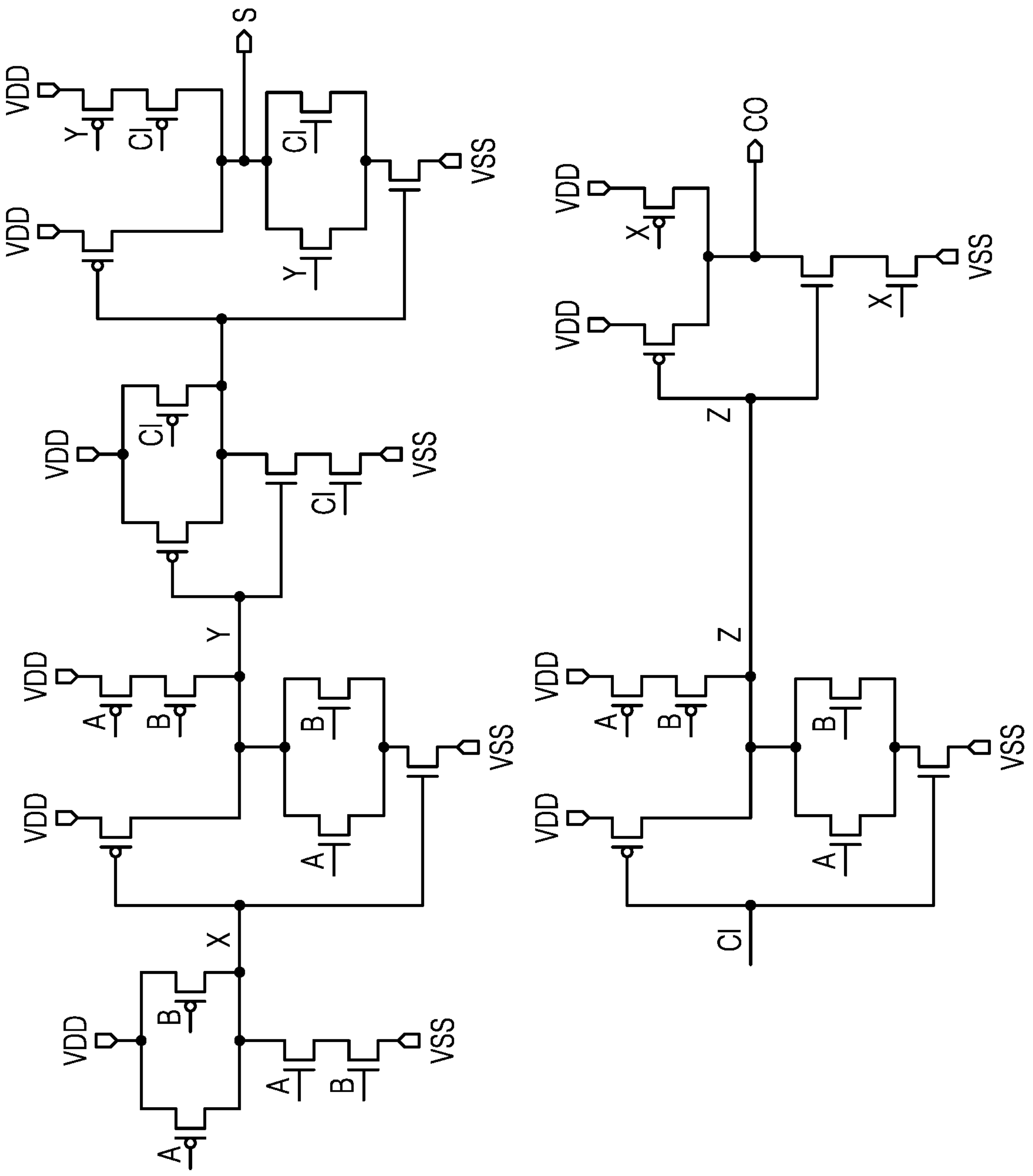


FIG. 2 (PRIOR ART)

FIG. 3 (PRIOR ART)

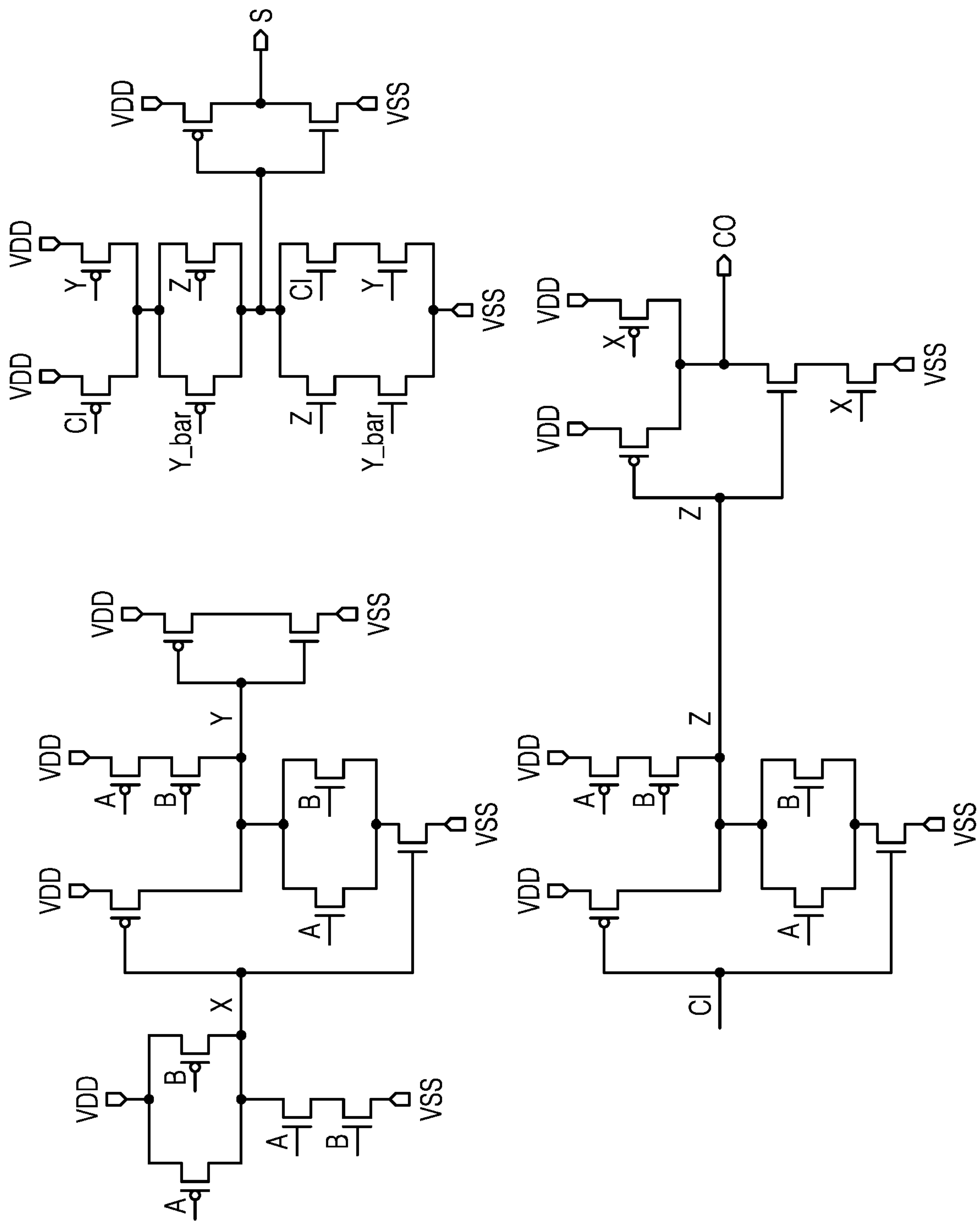

FIG. 4 (PRIOR ART)

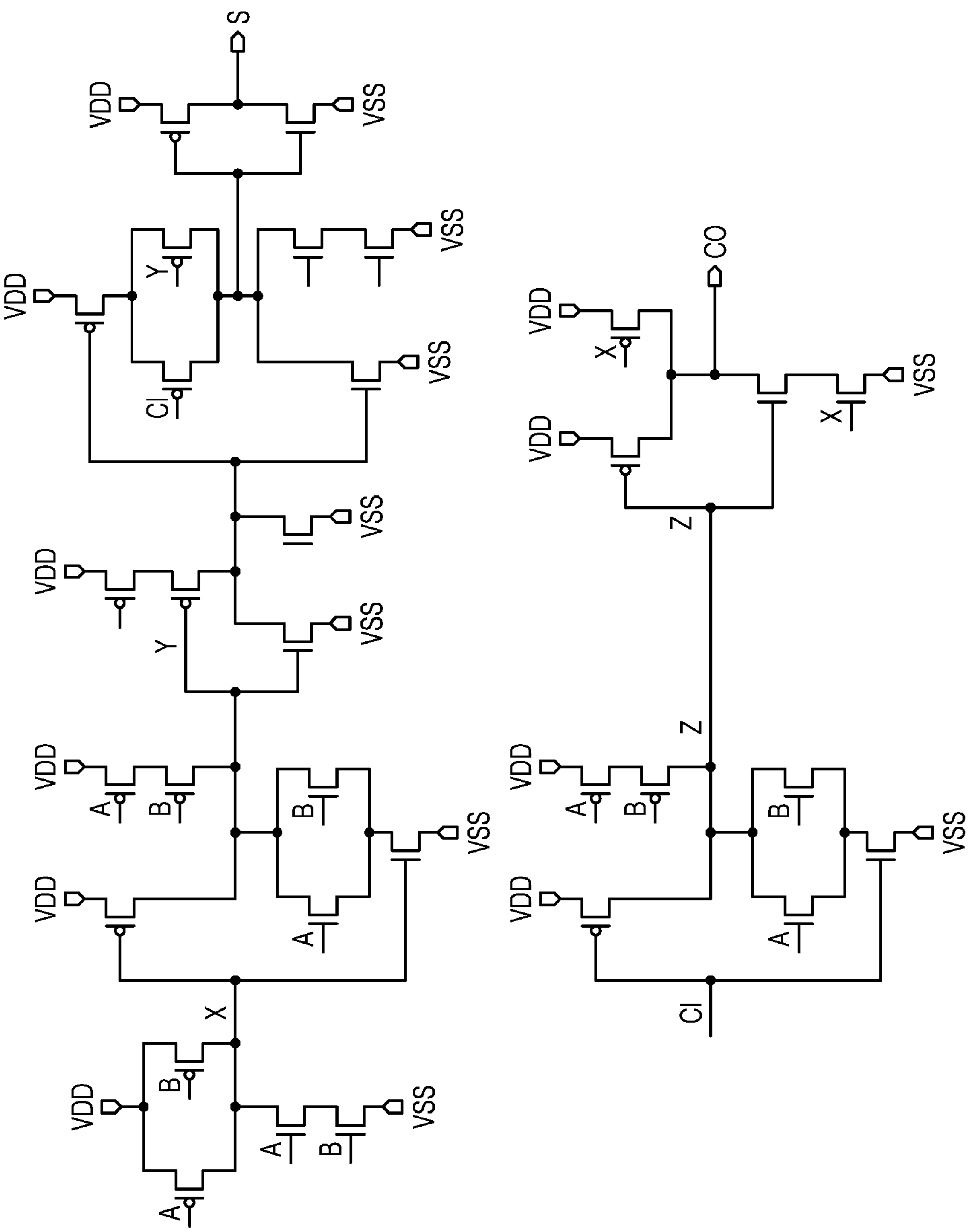

FIG. 5A (PRIOR ART)

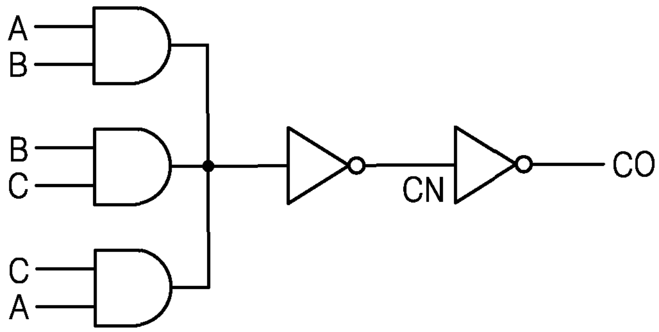

FIG. 5B (PRIOR ART)

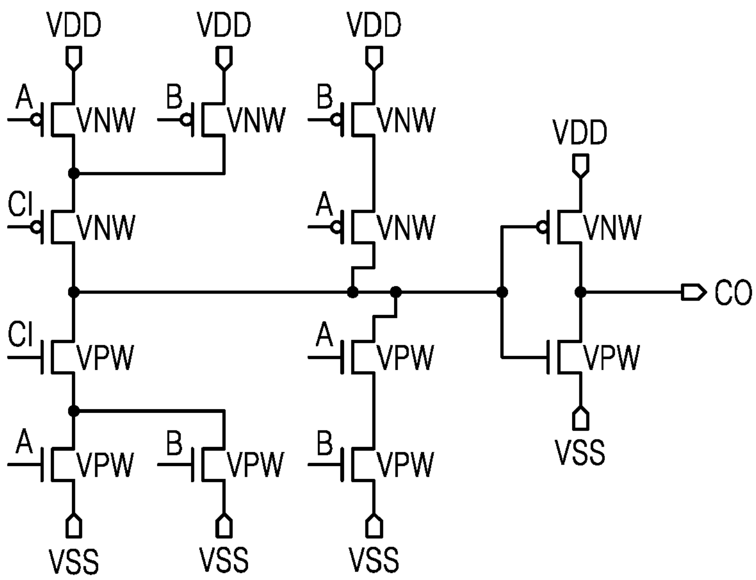

FIG. 6

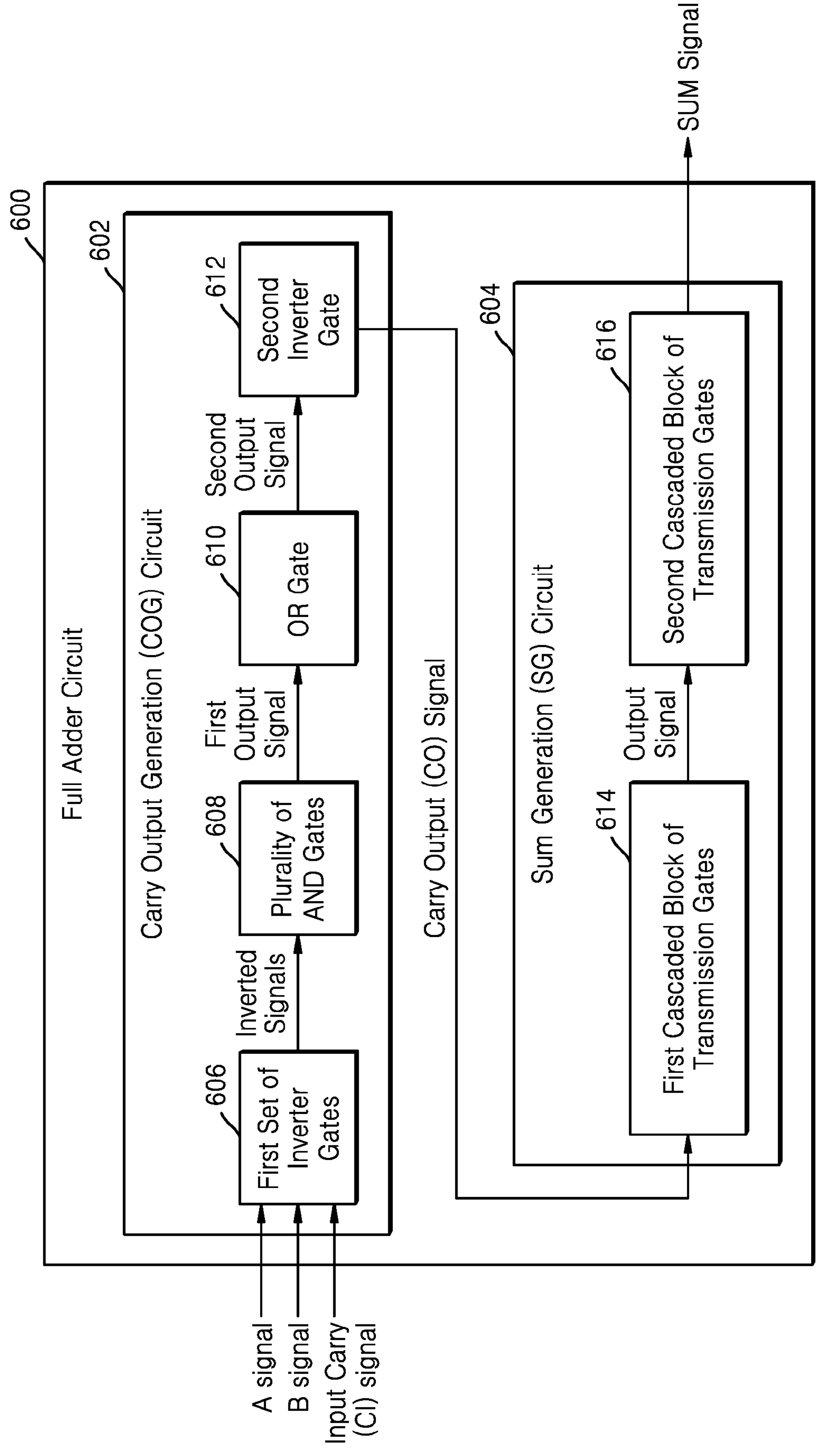
600
Full Adder Circuit
602
Carry Output Generation (COG) Circuit
606
First Set of Inverter Gates
Inverted Signals
608
Plurality of AND Gates
First Output Signal
610
OR Gate
Second Output Signal
612
Second Inverter Gate
Carry Output (CO) Signal
604
Sum Generation (SG) Circuit
614
First Cascaded Block of Transmission Gates
Output Signal
616
Second Cascaded Block of Transmission Gates
SUM Signal
A signal
B signal
Input Carry (CI) signal

FIG. 7

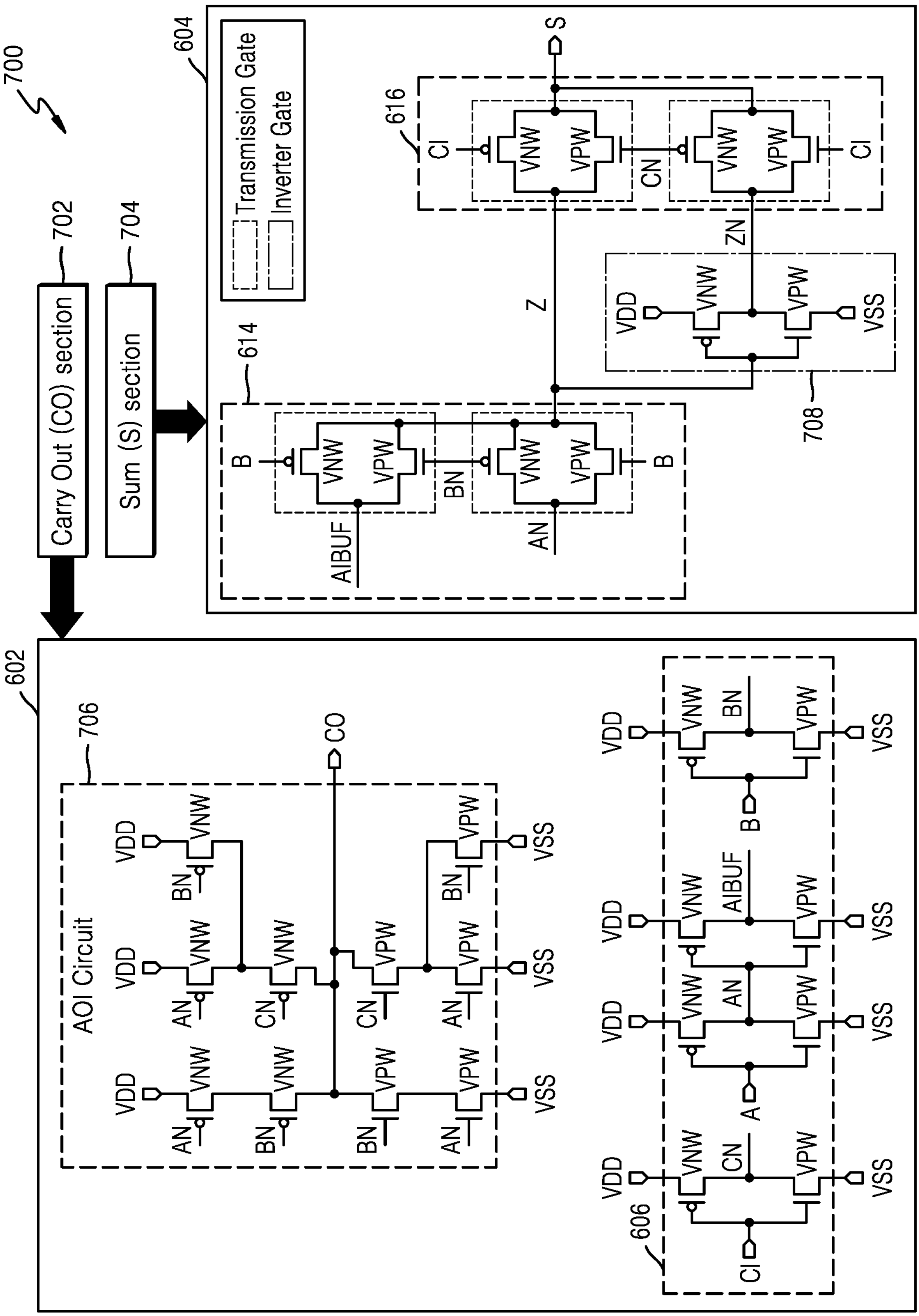
700
702
Carry Out (CO) section
704
Sum (S) section
604
Transmission Gate
Inverter Gate
614
616
708
602
706
AOI Circuit
606
AIBUF
AN
BN
B
Z
ZN
CN
CI
S
CO
A
VDD
VSS
VNW
VPW

FIG. 8

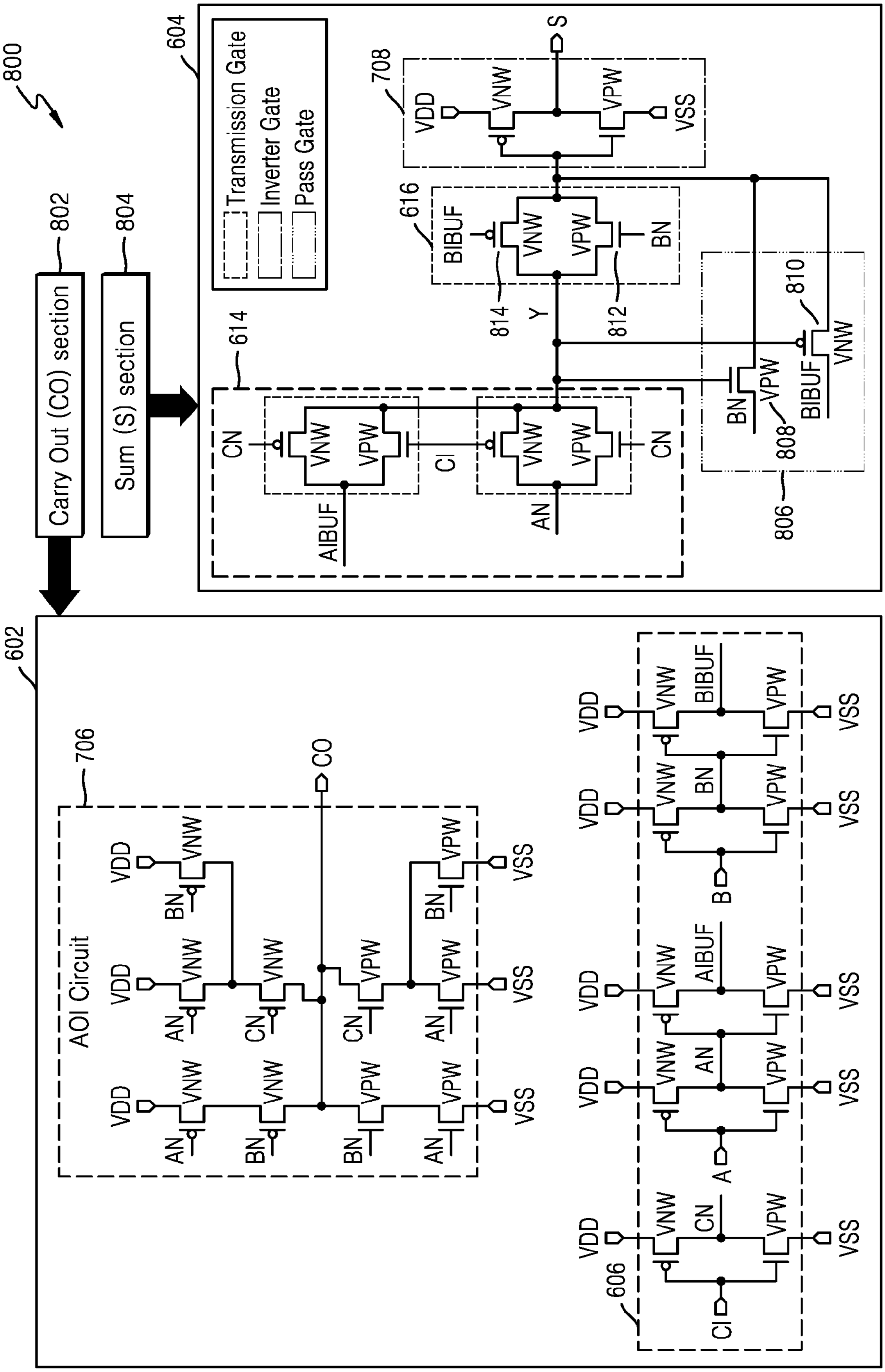
800
802
Carry Out (CO) section
804
Sum (S) section
604
Transmission Gate
Inverter Gate
Pass Gate
708
VDD
VNW
VPW
VSS
S
616
BIBUF
VNW
VPW
BN
814
Y
812
614
CN
VNW
VPW
CI
AIBUF
AN
810
808
806
BN
VPW
BIBUF
VNW
602
706
AOI Circuit
AN
BN
CN
VDD
VNW
VPW
VSS
CO
606
CI
A
B
AIBUF
BIBUF

FIG. 9

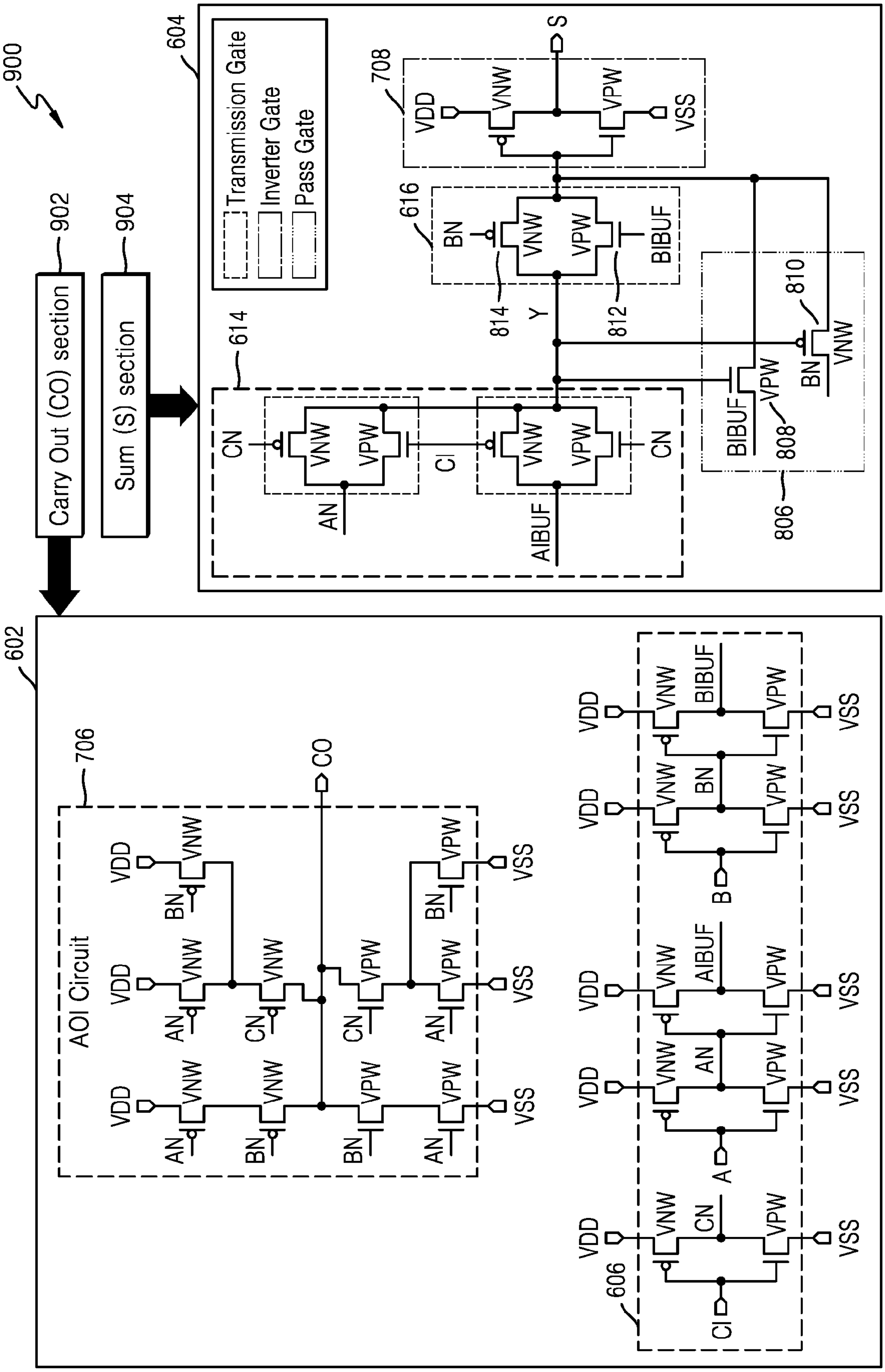
900
Carry Out (CO) section
902
Sum (S) section
904
604
Transmission Gate
Inverter Gate
Pass Gate
614
CN
AN
VNW
VPW
CI
AIBUF
616
BN
BIBUF
814
Y
812
708
VDD
VSS
S
806
808
810
602
706
AOI Circuit
CO
606
A
B
AN
BN
CN
BIBUF
AIBUF

FIG. 10

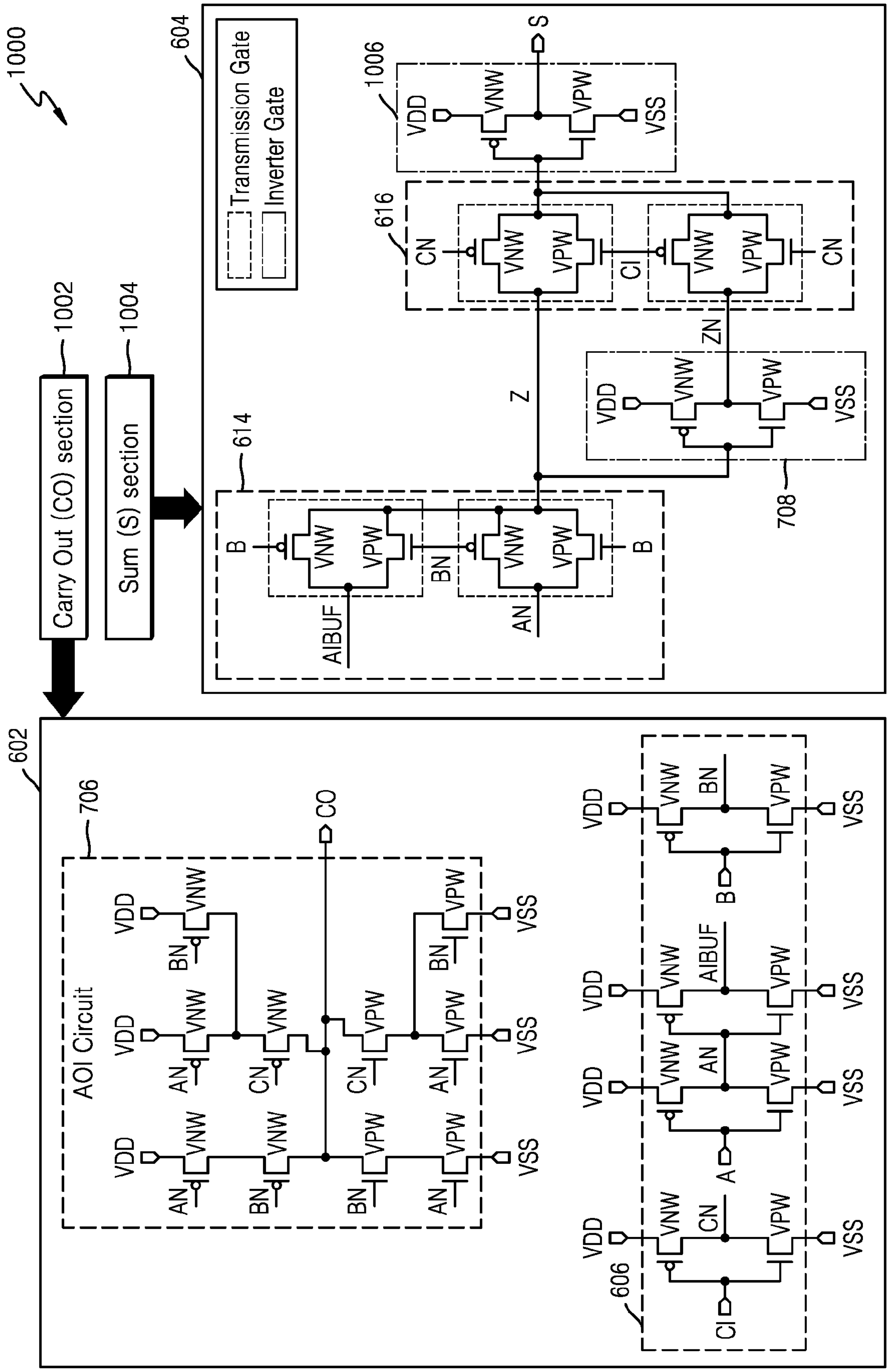
1000
1002
1004
Carry Out (CO) section
Sum (S) section
602
604
706
AOI Circuit
606
614
616
708
1006
Transmission Gate
Inverter Gate
VDD
VSS
VNW
VPW
AN
BN
CN
A
B
CI
CO
AIBUF
Z
ZN
S

FIG. 11

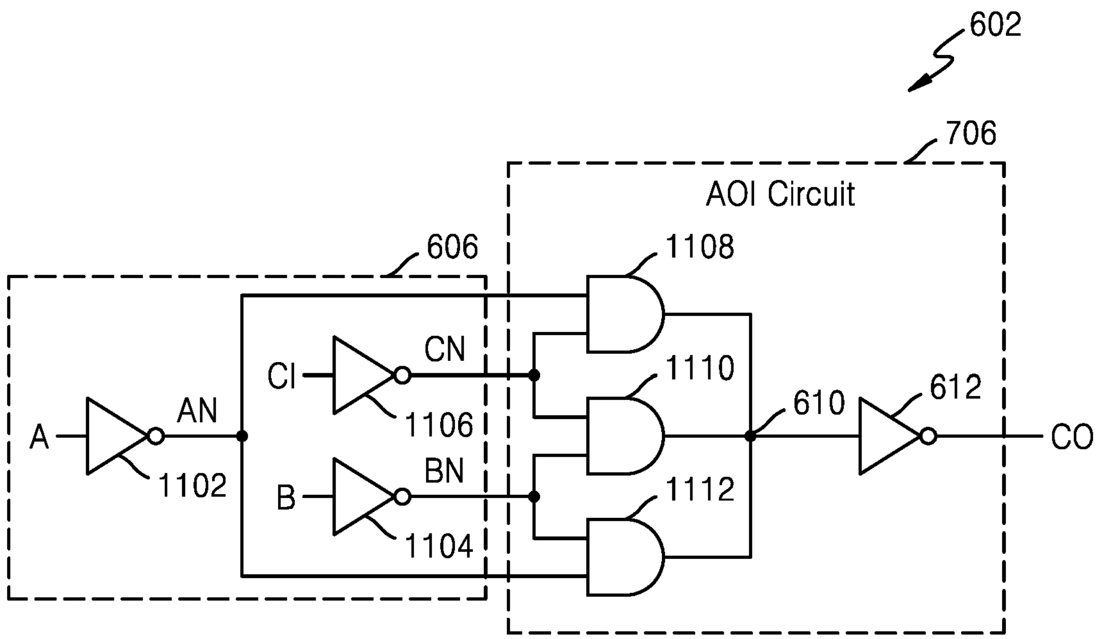
602
706
AOI Circuit
606
1108
CN
CI
1106
1110
610
612
A
AN
CO
1102
B
BN
1112
1104

FIG. 12

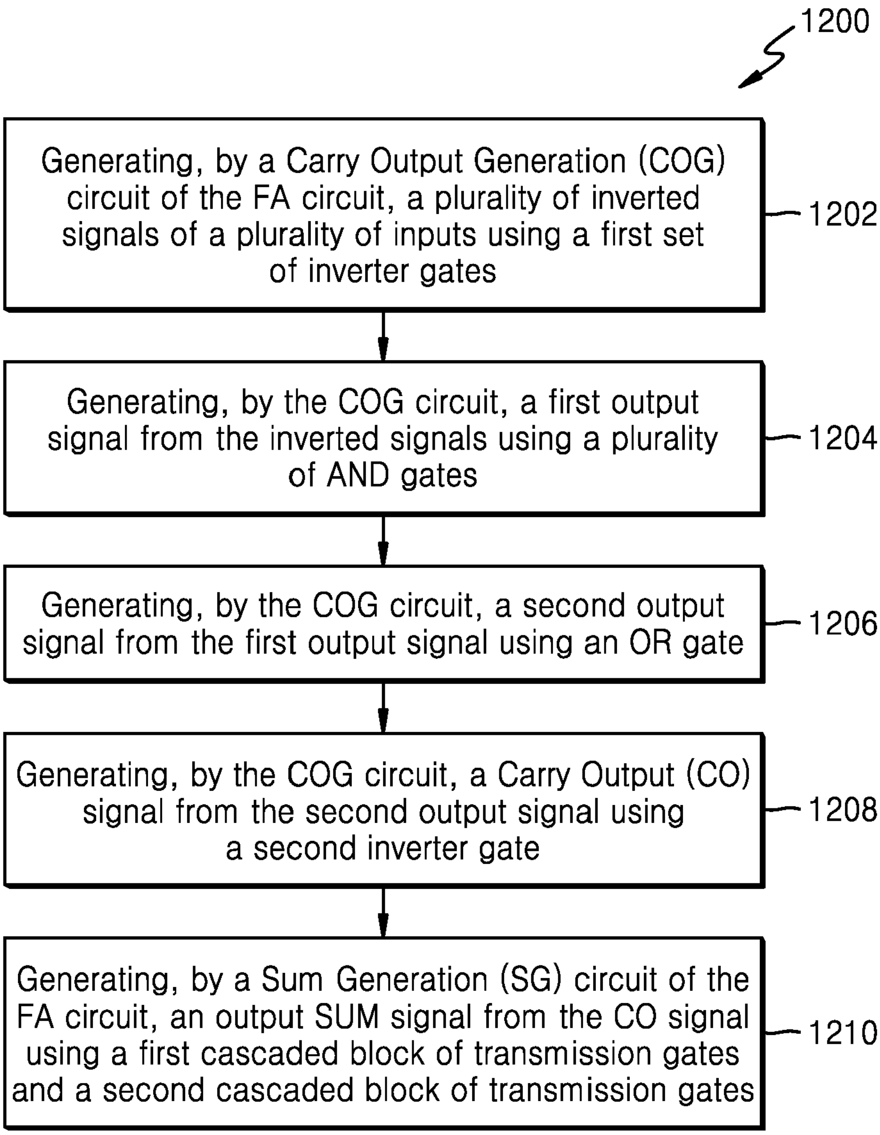
1200
Generating, by a Carry Output Generation (COG) circuit of the FA circuit, a plurality of inverted signals of a plurality of inputs using a first set of inverter gates
1202
Generating, by the COG circuit, a first output signal from the inverted signals using a plurality of AND gates
1204
Generating, by the COG circuit, a second output signal from the first output signal using an OR gate
1206
Generating, by the COG circuit, a Carry Output (CO) signal from the second output signal using a second inverter gate
1208
Generating, by a Sum Generation (SG) circuit of the FA circuit, an output SUM signal from the CO signal using a first cascaded block of transmission gates and a second cascaded block of transmission gates
1210

Europäisches Patentamt
European Patent Office
Office européen des brevets

# EUROPEAN SEARCH REPORT

Application Number
EP 24 17 6547

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 10 672 756 B2 (SAMSUNG ELECTRONICS CO LTD [KR]) 2 June 2020 (2020-06-02)<br>* figures 1, 3 *<br>----- | 1-15 | INV.<br>G06F7/501 |
| A | SINGH MATHURENDRA ET AL: "Relative Performance Analysis of Different Full Adder Using FINFET Technology",<br>2022 IEEE DELHI SECTION CONFERENCE (DELCON), IEEE,<br>11 February 2022 (2022-02-11), pages 1-5, XP034114086,<br>DOI: 10.1109/DELCON54057.2022.9753309<br>* Section II C.;<br>figure 3 *<br>----- | 1-15 | |
| A | US 2016/092170 A1 (NANDI SUVAM [IN] ET AL) 31 March 2016 (2016-03-31)<br>* paragraph [0011] - paragraph [0026];<br>figure 1 *<br>----- | 1-15 | |
| | | | TECHNICAL FIELDS SEARCHED (IPC) |
| | | | G06F |

1

The present search report has been drawn up for all claims

| Place of search | Date of completion of the search | Examiner |
|---|---|---|
| Munich | 22 October 2024 | Prins, Leendert |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................
& : member of the same patent family, corresponding document

EPO FORM 1503 03.82 (P04C01)

# ANNEX TO THE EUROPEAN SEARCH REPORT ON EUROPEAN PATENT APPLICATION NO.

EP 24 17 6547

This annex lists the patent family members relating to the patent documents cited in the above-mentioned European search report. The members are as contained in the European Patent Office EDP file on
The European Patent Office is in no way liable for these particulars which are merely given for the purpose of information.

22-10-2024

| Patent document cited in search report | Publication date | Patent family member(s) | Publication date |
|---|---|---|---|
| US 10672756 B2 | 02-06-2020 | CN 111147068 A | 12-05-2020 |
| | | US 2020144245 A1 | 07-05-2020 |
| | | US 2020266185 A1 | 20-08-2020 |
| US 2016092170 A1 | 31-03-2016 | CN 105471424 A | 06-04-2016 |
| | | US 2016092170 A1 | 31-03-2016 |

EPO FORM P0459

For more details about this annex : see Official Journal of the European Patent Office, No. 12/82